# DEMANDE DE BREVET EUROPEEN

(11) **EP 1 441 360 A1**
(43) Date de publication de la demande: **28.07.2004**
(21) Numéro de dépôt: 04000808.8
(22) Date de dépôt: 16.01.2004
(51) Int. Cl.: G11C 8/08, G11C 16/08

(54) **Décodeur de ligne de mot à tension négative, ayant des éléments de terminaison de faible encombrement**

(30) Priorité: 21.01.2003 FR 0300615
(71) Demandeur: STMicroelectronics, 92210 Montrouge (FR)
(72) Inventeur: Leconte, Bruno, 13790 Rousset (FR); Zink,Sebastien, 13090 Aix en Provence (FR); Cavaleri, Paola, 13790 Rousset (FR)
(74) Mandataire: Marchand, André

(57) **Abrégé**

La présente invention concerne un décodeur d'adresse (WLDEC2) pour appliquer sélectivement à des lignes de mot (WLi,j) d'un plan mémoire (MA) des signaux individuels (Vi,j) de polarité variable, négative ou positive, dont la valeur est fonction d'une adresse (ADR) de ligne de mot appliquée au décodeur. Le décodeur selon l'invention comprend un décodeur de groupe (GPGEN) délivrant des signaux (GPi) de sélection de groupe de lignes de mot (GRPi) de polarité variable (VPOS, VNEG), au moins un décodeur de sous-groupe (DECGEN, SPGEN) délivrant des signaux (SPj, DECj) de sélection de sous-groupe de lignes de mot de polarité variable, et des pilotes de ligne de mot (Di,j) comprenant chacun des moyens de multiplexage des signaux de sélection de groupe et de sous-groupe, pour sélectionner et appliquer sélectivement l'un de ces signaux à une ligne de mot. Avantages : réduction de l'encombrement des éléments de terminaison des décodeurs en relation avec la réduction du pas technologique dans les mémoires Flash.

## Description

La présente invention concerne un décodeur de ligne de mot à tension négative sélective, notamment pour mémoire Flash.

La présente invention vise plus particulièrement un perfectionnement d'un décodeur du type décrit dans la demande WO 02/41322 (figures 5 et 6), permettant d'appliquer sélectivement à des lignes de mot d'un plan mémoire des tensions d'effacement négatives, et de réaliser ainsi les mémoires Flash effaçables par page, une page représentant une ligne de mot.

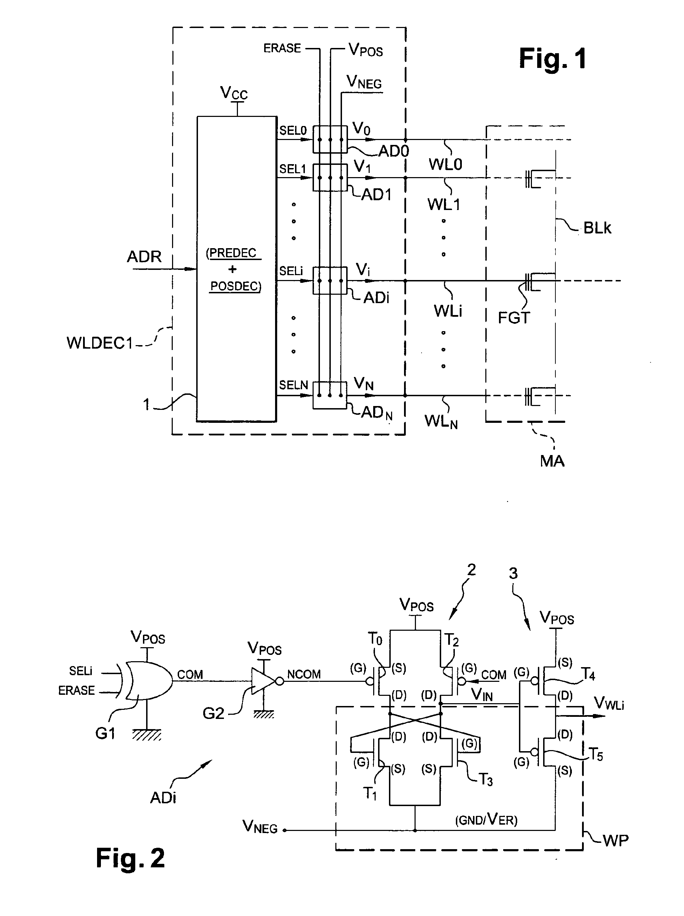

La figure 1 représente très schématiquement un plan mémoire Flash MA et un décodeur de ligne de mot WLDEC1 du type décrit dans la demande susmentionnée. Le plan mémoire MA comprend des transistors à grille flottante FGT agencés en lignes et en colonnes, formant chacun une cellule mémoire rémanente. Les transistors FGT ont leurs grilles de commande reliées à des lignes de mot WLi et leurs sources ou leurs drains reliés à des lignes de bit BLk.

Le décodeur WLDEC1 comprend un prédécodeur PREDEC et un postdécodeur POSTDEC alimentés par une tension Vcc, fournissant des signaux de sélection de lignes de mot SELi. Lorsqu'une adresse déterminée ADR est fournie au décodeur, le signal de sélection SELi de la ligne de mot WLi désignée par cette adresse est mis à 1 (tension Vcc) tandis que tous les autres signaux de sélection sont à 0 (masse). Les signaux SELi sont appliqués à des circuits adaptateurs de tension ADi délivrant chacun une tension Vi à une ligne de mot WLi. Chaque adaptateur de tension ADi reçoit également un signal ERASE, une tension VPOS et une tension VNEG. La tension Vi peut être positive, négative ou nulle selon l'opération en cours d'exécution, la valeur du signal de sélection SELi et la valeur des tensions VPOS, VNEG.

Comme cela est décrit par le tableau 1 ci-après, le signal ERASE est à 1 dans le mode effacement et à 0 dans les autres modes de fonctionnement de la mémoire. La tension VPOS est égale à une tension de lecture VREAD dans le mode lecture, à une tension de programmation VPP dans le mode programmation et à une tension d'inhibition d'effacement VEINHIB dans le mode effacement. La tension VNEG est égale à une tension de non-lecture VNREAD dans le mode lecture, à une tension d'inhibition de programmation VPINHIB dans le mode programmation et à une tension d'effacement négative VER dans le mode effacement.

La figure 2 représente l'architecture d'un adaptateur de tension ADi. L'adaptateur ADi comprend une porte G1 de type OU EXCLUSIF recevant en entrée les signaux SELi et ERASE et délivrant un signal COM. Le signal COM est appliqué à une porte inverseuse G2 délivrant un signal NCOM. Les portes G1, G2 sont alimentées par la tension VPOS et les signaux COM, NCOM sont portés à la tension VPOS lorsqu'ils sont à 1. Les signaux COM et NCOM sont appliqués à un étage pilote 2 dont la sortie commande un étage inverseur 3. L'étage pilote 2 comprend deux branches en parallèle comportant chacune un transistor PMOS en série avec un transistor NMOS, respectivement T0, T1 et T2, T3. Les sources des transistors T0 et T2 reçoivent la tension VPOS tandis que les sources des transistors T1 et T3 reçoivent la tension VNEG. Le noeud de drain des transistors T2, T3 est connecté à la grille du transistor T1 et le noeud de drain des transistors T0, T1 est connecté à la grille du transistor T3. L'étage inverseur 3 comprend un transistor PMOS T4 en série avec un transistor NMOS T5. La source du transistor T4 reçoit la tension VPOS et la source du transistor T5 reçoit la tension VNEG. Les grilles des transistors T4, T5 sont reliées au noeud de drain des transistors T2, T3, et le noeud de drains des transistors T4, T5 fournit la tension Vi. Les transistors NMOS T1, T3 et T5 sont réalisés dans un caisson WP de type P isolé du substrat par un caisson N, selon la technique connue de triple caisson.

La fonction de transfert des adaptateurs de tension ADi est décrite par le tableau 1 ci-après. Dans le mode effacement de page (ERASE=1) la tension Vi appliquée à une ligne de mot WLi est égale à VER si la ligne de mot est sélectionnée (SELi=1) ou à VEINHIB si la ligne de mot n'est pas sélectionnée (SELi=0), la tension VEINHIB étant ici égale à 4V. En dehors des périodes d'effacement, la tension Vi appliquée à une ligne de mot WLi sélectionnée est égale à la tension VPOS et la tension Vi appliquée à une ligne de mot WLi non sélectionnée (SELi=0) est nulle.

**Tableau 1**

| **Mode** | **SELi** | **ERASE** | **COM** | **NCOM** | **Vi** |
|---|---|---|---|---|---|
| Lecture | 0 | 0 | 0 | 1 | Vi = VNEG = VNREAD = 0V (GND) |
| | 1 | 0 | 1 | 0 | Vi = VPOS = VREAD = 4.5V |
| Programmation | 0 | 0 | 0 | 1 | Vi = VNEG = VPINHIB = 0V (GND) |
| | 1 | 0 | 1 | 0 | Vi = VPOS = VPP (8 - 10V) |
| Effacement | 0 | 1 | 1 | 0 | Vi = VPOS = VEINHIB (4V) |
| | 1 | 1 | 0 | 1 | Vi = VNEG = VER (-8V) |

Un tel décodeur à tension négative, bien qu'apportant en soi toute satisfaction, présente l'inconvénient que les adaptateurs de tension ADi, qui forment les éléments de terminaison du décodeur, sont d'une structure relativement complexe.

Or, avec l'évolution des procédés de fabrication des mémoires Flash, le pas technologique des mémoires ("pitch"), c'est-à-dire la distance minimale entre deux lignes de mot, se réduit de plus en plus. Il apparaît ainsi que la surface de silicium disponible en face de chaque ligne de mot WLi devient trop faible pour permettre l'intégration des adaptateurs de tension ayant la structure décrite ci-dessus.

Ainsi, la présente invention vise une structure de décodeur de ligne de mot à tension négative sélective qui soit compatible avec la réduction du pas technologique dans les mémoires non volatiles, notamment les mémoires Flash.

Plus particulièrement, la présente invention vise une structure de décodeur de ligne de mot à tension négative sélective qui comporte des éléments de terminaison de faible encombrement.

Ces objectifs sont atteints par la prévision d'un décodeur d'adresse pour appliquer sélectivement à des lignes de mot d'un plan mémoire des signaux de polarité variable, négative ou positive, dont la valeur est fonction d'une adresse de ligne de mot appliquée au décodeur, comprenant un décodeur de groupe délivrant des signaux de sélection de groupe de lignes de mot qui sont de polarité variable, au moins un décodeur de sous-groupe délivrant des signaux de sélection de sous-groupe de lignes de mot qui sont également de polarité variable, un sous-groupe de lignes de mot comprenant un ensemble de lignes de mot appartenant à des groupes de lignes de mot différents, et des pilotes de ligne de mot à raison d'un pilote de ligne de mot par ligne de mot, comprenant chacun des moyens de multiplexage des signaux de sélection de groupe et de sous-groupe, pour sélectionner et appliquer sélectivement un de ces signaux à une ligne de mot.

Selon un mode de réalisation, un groupe de lignes de mot comprend un ensemble de lignes de mot ayant des bits d'adresse de poids déterminé identiques, et un sous-groupe de lignes de mot comprend un ensemble de lignes de mot ayant des bits d'adresse de poids déterminé identiques, tout en appartenant à des groupes de lignes de mot différents.

Selon un mode de réalisation, un groupe de lignes de mot comprend un ensemble de lignes de mot ayant des bits d'adresse de poids fort identiques, et un sous-groupe de lignes de mot comprend un ensemble de lignes de mot ayant des bits d'adresse de poids faible identiques.

Selon un mode de réalisation, un pilote de ligne de mot comprend des transistors interrupteurs de type MOS qui sont à la fois pilotés sur leur grille et polarisés sur leur drain et leur source par les signaux de sélection de groupe et de sous-groupe, et sont agencés pour sélectionner un de ces signaux et l'appliquer à une ligne de mot.

Selon un mode de réalisation, un pilote de ligne de mot comprend des transistors interrupteurs ayant chacun une borne reliée à une ligne de mot, une borne recevant un signal de sélection de groupe ou de sous-groupe, et une grille recevant un signal de sélection de groupe ou de sous-groupe.

Selon un mode de réalisation, le décodeur de sous-groupe comprend un premier décodeur de sous-groupe, délivrant des premiers signaux de sélection de sous-groupe dont la valeur est fonction de l'adresse de ligne de mot appliquée au décodeur pendant des phases d'effacement de cellules mémoire, et est indépendante de l'adresse appliquée au décodeur pendant des phases de lecture ou de programmation de cellules mémoire ; et un second décodeur de sous-groupe délivrant des seconds signaux de sélection de sous-groupe dont la valeur est fonction de l'adresse de ligne de mot appliquée au décodeur pendant les phases de lecture ou de programmation, et est indépendante de l'adresse appliquée au décodeur pendant les phases d'effacement.

Selon un mode de réalisation, chacun des décodeurs de sous-groupe reçoit une première et une seconde tension de référence et fournit, en sus d'un signal de sélection de sous-groupe, un signal complémentaire de sélection de sous-groupe égal à la seconde tension de référence quand le signal de sélection de sous-groupe est égal à la première tension de référence et égal à la première tension de référence quand le signal de sélection de sous-groupe est égal à la seconde tension de référence.

Selon un mode de réalisation, un pilote de ligne de mot comprend des transistors MOS dont les grilles sont pilotées par l'un des signaux complémentaires, et des transistors MOS dont les grilles sont pilotées par des signaux de sélection de groupe.

Selon un mode de réalisation, un pilote de ligne de mot comprend un premier transistor MOS ayant une borne de drain ou de source reliée à une ligne de mot, recevant sur sa grille un signal de sélection de groupe et recevant sur une borne de source ou de drain un premier signal de sélection de sous-groupe, un deuxième transistor MOS ayant une borne de drain ou de source reliée à la ligne de mot, recevant sur sa grille le signal de sélection de groupe et recevant sur une borne de source ou de drain un second signal de sélection de sous-groupe, un troisième transistor MOS ayant une borne de drain ou de source reliée à la ligne de mot, recevant sur sa grille un premier signal complémentaire de sélection de sous-groupe et recevant sur une borne de source ou de drain un second signal de sélection de sous-groupe, et un quatrième transistor MOS ayant une borne de drain ou de source reliée à la ligne de mot, recevant sur sa grille un second signal complémentaire de sélection de sous-groupe et recevant sur une borne de source ou de drain un premier signal de sélection de sous-groupe.

Selon un mode de réalisation, les décodeurs de groupe et de sous-groupe reçoivent deux tensions de référence qui sont respectivement égales à une tension de non-lecture et à une tension de lecture pendant la lecture de cellules mémoire.

Selon un mode de réalisation, les décodeurs de groupe et de sous-groupe reçoivent deux tensions de référence qui sont respectivement égales à une tension d'inhibition de programmation et à une tension de programmation pendant la programmation de cellules mémoire.

Selon un mode de réalisation, les décodeurs de groupe et de sous-groupe reçoivent deux tensions de référence qui sont respectivement égales à une tension d'effacement et à une tension d'inhibition d'effacement pendant l'effacement de cellules mémoire.

Selon un mode de réalisation, la tension de programmation est positive, la tension d'inhibition de programmation et la tension d'effacement sont négatives, les tensions de non lecture et d'inhibition d'effacement sont nulles.

Selon un mode de réalisation, le décodeur comprend un étage de prédécodage fournissant des signaux de prédécodage aux décodeurs de groupe et de sous-groupe.

Selon un mode de réalisation, le décodeur de groupe et le décodeur de sous-groupe fournissent des signaux de sélection positifs, négatifs ou nuls.

Selon un mode de réalisation, le décodeur de groupe comprend des circuits élévateurs de tension pour transformer un signal logique égal à 1 ayant un niveau de tension positif déterminé en un signal logique ayant un niveau de tension positif de valeur supérieure, égal à une tension de référence fournie aux circuits élévateurs de tension.

Selon un mode de réalisation, les décodeurs de groupe et de sous-groupe comprennent des commutateurs de tension pour transformer des signaux logiques à 0 et à 1 en des signaux ayant des niveaux de tension négatifs différents.

Selon un mode de réalisation, les décodeurs de groupe et de sous-groupe comprennent des commutateurs de tension agencés pour transformer un signal logique à 0 en un signal de tension négative et signal logique à 1 en un signal de tension positive.

Ces objets, caractéristiques et avantages ainsi que d'autres de la présente invention seront exposés plus en détail dans la description suivante d'un exemple de réalisation d'un décodeur selon l'invention, faite à titre non limitatif en relation avec les figures jointes parmi lesquelles :
- la figure 1 précédemment décrite représente la structure générale d'un décodeur de ligne de mot à tension négative classique,
- la figure 2 représente la structure d'un adaptateur de tension présent dans le décodeur de la figure 1,
- la figure 3A représente la structure générale d'un décodeur de ligne de mot selon l'invention, intégré dans une mémoire Flash,
- la figure 3B représente un générateur de tension d'alimentation représenté sous forme de bloc en figure 3A,
- la figure 4 représente la structure d'un pilote de ligne de mot représenté sous forme de bloc en figure 3A,
- les figures 5A à 5L représentent le pilote de ligne de mot de la figure 4 dans diverses configurations de fonctionnement,
- la figure 6 représente l'architecture d'un décodeur de groupe représenté sous forme de bloc en figure 3A,
- la figure 7 représente l'architecture d'un premier décodeur de sous-groupe représenté sous forme de bloc en figure 3A,
- la figure 8 représente l'architecture d'un second décodeur de sous-groupe représenté sous forme de bloc en figure 3A,
- la figure 9 est le schéma électrique d'un circuit élévateur de tension représenté sous forme de bloc en figure 6, et
- la figure 10 est le schéma électrique d'un commutateur de tension négative représenté sous forme de bloc en figures 6, 7 et 8.

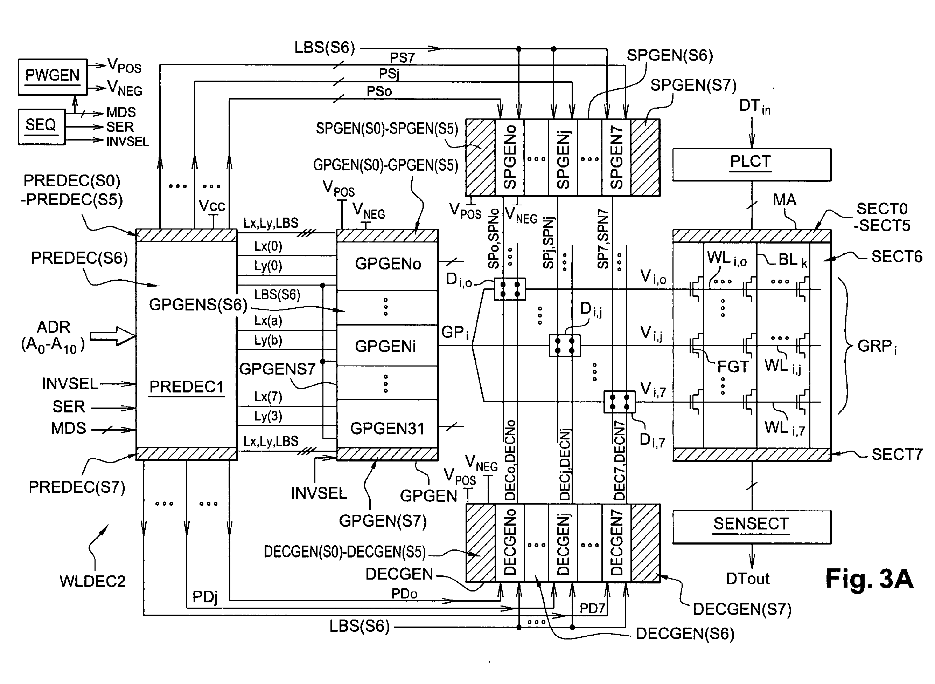

La figure 3A est un schéma d'ensemble d'une mémoire Flash comprenant un décodeur de ligne de mot WLDEC2 selon l'invention et un plan mémoire Flash MA. Le décodeur WLDEC2 reçoit ici une adresse de ligne de mot ADR codée sur 11 bits A0 à A10. Le plan mémoire MA comprend des lignes de mot WLi,j, des lignes de bit BLk (i, j, k étant des indices) et des transistors à grille flottante FGT. Chaque transistor FGT a une grille connectée à une ligne de mot et une borne de drain ou de source connectée à une ligne de bit, et forme une cellule mémoire effaçable et programmable électriquement. Les lignes de bit BLk sont reliées à un circuit de programmation PLCT et à un circuit de lecture SENSECT. Le circuit PLCT comprend des verrous de programmation, pour recevoir des données DTin à enregistrer dans les cellules mémoire lors d'une phase de programmation. Le circuit de lecture SENSECT comprend des amplificateurs de lecture ("sense amplifiers") pour lire des données DTout dans les cellules mémoire lors d'une phase de lecture.

### Organisation du plan mémoire

Le plan mémoire comprend ici 8 secteurs SCT0 à SCT7 désignés par les 3 bits d'adresse de plus fort poids A0-A2, et chaque secteur comprend 256 lignes de mot (seul le secteur SCT6 étant représenté de façon partielle). Ce découpage en secteurs est toutefois optionnel et n'est décrit ici qu'à titre d'exemple concret de mise en oeuvre de l'invention.

L'architecture du décodeur WLDEC2 repose sur un découpage de chaque secteur (ou du plan mémoire dans sa totalité si un seul secteur est prévu) en groupes de lignes de mot et en sous-groupes de lignes de mot, tels que l'intersection d'un groupe de lignes de mot et d'un sous-groupe de lignes de mot corresponde à une ligne de mot et une seule.

Ce découpage est effectué ici ainsi :
- les 5 bits d'adresse de poids forts A3-A7 désignent un groupe de ligne de mot, et
- les 3 bits d'adresse de plus faible poids A8-A10 désignent un sous-groupe de lignes de mot.

Naturellement, les bits d'adresse de plus fort poids A0-A2 seraient des bits de désignation de groupe si le plan mémoire ne comportait pas de secteur.

Chaque secteur comprend ainsi 32 groupes de 8 lignes de mot et 8 sous-groupes de 8 lignes de mot, et chaque groupe comprend 8 lignes de mot qui appartiennent chacune à l'un des 8 sous-groupes, un sous-groupe ne comprenant que des lignes de mot appartenant à des groupes différents. Dans ce qui suit, un groupe est désigné GRPi et le rang d'un groupe désigné par l'indice "i", le rang d'un sous-groupe étant désigné par l'indice "j". Une ligne de mot appartenant à un groupe de rang i et à un sous-groupe de rang j est désignée WLi,j. La figure 3A représente à titre d'exemple les lignes de mot WLi, 0 ...WLi, j...WLi, 7 d'un groupe GRPi de rang i du secteur SCT6 (l'indice i étant compris ici entre 0 et 31) .

### Architecture du décodeur WLDEC2

Le décodeur WLDEC2 présente une architecture correspondant au découpage du plan mémoire en groupes et en sous-groupes, et comprend :
- un prédécodeur PREDEC1 alimenté par une tension Vcc,
- un décodeur de groupe GPGEN selon l'invention,
- deux décodeurs de sous-groupe DECGEN, SPGEN selon l'invention,
- des pilotes de ligne de mot Di,j ("Word line drivers") selon l'invention, à raison d'un pilote Di,j par ligne de mot, chaque pilote de ligne de mot fournissant une tension Vi, j à une ligne de mot WLi,j de rang correspondant.

### Prédécodeur PREDEC1

Le prédécodeur PREDEC1 fournit au décodeur de groupe GPGEN des signaux de sélection de groupe Lx(a), Ly(b), LBS.

Le signal LBS est fonction des 3 bits d'adresse de plus fort poids A0-A2 et est identique pour tous les groupes de lignes de mot d'un même secteur. Si par exemple les bits d'adresse A0-A2 désignent le secteur SECT6, le signal LBS (S6) fourni par le prédécodeur pour tous les groupes de lignes de mot de ce secteur est à 1.

Les signaux Lx(a), Ly(b) sont fonction des 5 bits d'adresse de poids forts A3-A7 et comprennent ici 8 signaux Lx (0) à Lx (7) et 4 signaux Ly(0) à Ly(3), permettant d'obtenir 32 combinaisons différentes de signaux, en commençant par la combinaison Lx(0)/Ly(0) et en terminant par la combinaison Lx(7)/Ly(3). Ainsi, chaque combinaison de signaux Lx(a), Ly(b) correspond à un groupe et un seul parmi les 32 groupes du secteur.

Le prédécodeur PREDEC1 fournit également des signaux de sélection de sous-groupe PDj qui sont appliqués au décodeur de sous-groupe DECGEN, ici 8 signaux de sélection PD0 à PD7, et des signaux de sélection de sous-groupe PSj qui sont appliqués au décodeur de sous-groupe SPGEN, ici 8 signaux de sélection PS0 à PS7. Ces signaux sont fonction des 3 bits d'adresse de plus faible poids A8-A10.

Le prédécodeur PREDEC1 comprend 8 blocs de prédécodage PREDEC1 (S0) à PREDEC1(S7), à raison d'un bloc par secteur, chaque bloc de décodage étant relié à un bloc de décodage du décodeur GPGEN décrit ci-après. Les signaux fournis par le bloc PREDEC(S6) sont partiellement représentés sur la figure 3A.

### Décodeur de groupe GPGEN

Le décodeur de groupe GPGEN comprend un bloc de décodage par secteur, soit ici 8 blocs de décodage GPGEN (S0) à GPGEN (S7). Chaque bloc de décodage comprend des éléments de décodage GPGENi en nombre égal au nombre de groupes de lignes de mot par secteur, soit ici 32 éléments de décodage GPGEN0 à GPGEN31. Les éléments de décodage du bloc GPGEN(S6) sont partiellement représentés en figure 3A. Chaque élément de décodage GPGENi de rang "i" fournit un signal de sélection GPi appliqué à tous les pilotes de ligne de mot Di,j (Di,0 à Di,7) du groupe de lignes de mot GRPi de rang correspondant.

Chaque élément de décodage GPGENi reçoit une combinaison de trois signaux de sélection Lx(a), Ly(b), LBS. Par exemple, l'élément de décodage GPGEN0 du bloc GPGEN(S6) reçoit la combinaison Lx (0) / Ly (0) / LBS (S6) et l'élément de décodage GPGEN31 reçoit la combinaison Lx (7) / Ly (3) / LBS (S6), le signal LBS étant identique pour toutes les lignes de mot du même secteur. Les signaux Lx(a), Ly(b) étant fonction des 5 bits d'adresse de poids forts A3-A7, un seul élément de décodage de groupe GPGENi dans chaque bloc de décodage reçoit une combinaison de signaux Lx(a)/Ly(b) égale à "11" (Vcc), et un seul élément de décodage GPGENi parmi tous les blocs de décodage reçoit une combinaison de signaux Lx (a) /Ly (b) /LBS égale à "111".

### Décodeur de sous-groupe DECGEN

Le décodeur de sous-groupe DECGEN comprend un bloc de décodage par secteur, soit ici 8 blocs de décodage DECGEN (S0) à DECGEN (S7). Chaque bloc de décodage comprend des éléments de décodage DECGENj en nombre égal au nombre de sous-groupes de lignes de mot par secteur, soit ici 8 éléments de décodage DECGEN0 à DECGEN7. Les éléments de décodage du bloc SPGEN(S6) sont partiellement représentés sur la figure 3A.

Chaque élément de décodage DECGENj de rang j reçoit un signal de sélection PDj de rang correspondant et le signal LBS de sélection du secteur correspondant. Par exemple, les éléments de décodage DECGEN0 et DECGEN7 du bloc DECGEN(S6) reçoivent respectivement des signaux de sélection PD0 et PD7 et le signal LBS (S6). Les signaux de sélection PD0 à PD7 sont communs à tous les blocs DECGEN (S0) à DECGEN (S7).

Chaque élément de décodage DECGENj de rang j fournit des signaux de sélection DECj, DECNj. Ces signaux de sélection sont appliqués aux pilotes de ligne de mot Di,j des lignes de mot appartenant au même sous-groupe de rang j. Les lignes de mot d'un même groupe GRPi appartenant chacune à un sous-groupe différent, les pilotes de ligne de mot Di,j reliés à ces lignes de mot reçoivent chacun une combinaison de signaux de sélection DECj, DECNj individuelle.

### Décodeur de sous-groupe SPGEN

Le décodeur de sous-groupe SPGEN, d'une architecture d'ensemble similaire à celle du décodeur de sous-groupe DECGEN, comprend un bloc de décodage par secteur, soit ici 8 blocs de décodage SPGEN (S0) à SPGEN(S7). Chaque bloc de décodage comprend des éléments de décodage SPGENj en nombre égal au nombre de sous-groupes de lignes de mot par secteur, soit ici 8 éléments de décodage SPGEN0 à SPGEN7. Les éléments de décodage du bloc SPGEN(S6) sont partiellement représentés sur la figure 3A.

Chaque élément de décodage SPGENj de rang j reçoit un signal de sélection PSj de rang correspondant et le signal LBS de sélection du secteur correspondant. Par exemple, les éléments de décodage SPGEN0 et SPGEN7 du bloc SPGEN(S6) reçoivent respectivement des signaux de sélection PS0 et PS7 et le signal LBS (S6). Les signaux de sélection PS0 à PS7 sont communs à tous les blocs SPGEN (S0) à SPGEN (S7) .

Chaque élément de décodage SPGENj de rang j fournit des signaux de sélection SPj, SPNj. Ces signaux de sélection sont appliqués aux pilotes de ligne de mot Di,j des lignes de mot appartenant au même sous-groupe de rang j. Les lignes de mot d'un même groupe GRPi appartenant chacune à un sous-groupe différent, les pilotes de ligne de mot Di,j reliés à ces lignes de mot reçoivent chacun une combinaison de signaux de sélection SPj, SPNj individuelle.

### Pilote de ligne de mot Di, j

A l'inverse du décodeur classique précédemment décrit, les pilotes de ligne de mot Di,j selon l'invention ne convertissent pas un signal de sélection du type 0/Vcc en une tension négative ou positive selon l'opération effectuée dans le plan mémoire (lecture, effacement, programmation). Les pilotes de ligne de mot sont ici de simples multiplexeurs de signaux dont la fonction est de combiner les signaux de polarité variable fournis par les éléments de décodage de groupe GPGENi et les éléments de décodage de sous-groupe DECGENj, SPGENj, soit les signaux GPi, SPj et SPNj, DECj et DECNj, pour obtenir des tensions Vi,j de polarité variable appliquées aux lignes de mot WLi,j. Les pilotes de ligne de mot peuvent être ainsi d'une structure très simple.

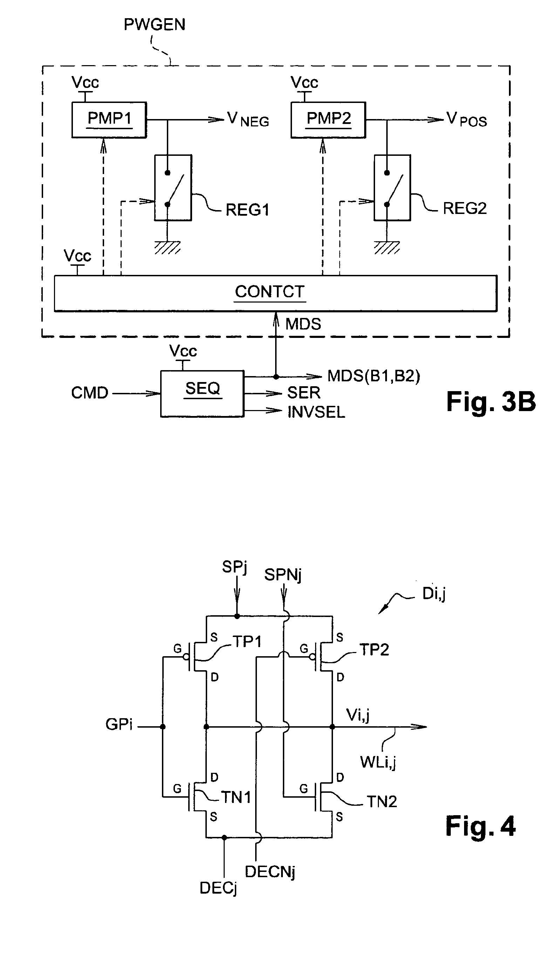

La figure 4 représente un mode de réalisation d'un pilote de ligne de mot Di,j nécessitant un faible nombre de transistors. Le pilote de ligne de mot Di,j comprend deux transistors interrupteurs PMOS TP1, TP2 et deux transistors interrupteurs NMOS TN1, TN2 agencés pour combiner les signaux GPi, SPj et SPNj, DECj et DECNj. Les transistors PMOS et NMOS sont implantés dans des caissons différents (respectivement caissons de type N et caissons de type P) d'une manière qui est en soi à la portée de l'homme de l'art et ne sera pas décrite ici.

Les transistors TP1, TP2 reçoivent sur leurs sources le signal SPj et les transistors TN1, TN2 reçoivent sur leurs sources le signal DECj. Les grilles des transistors TP1, TN1 reçoivent le signal GPi. La grille du transistor TP2 reçoit le signal DECNj et la grille du transistor TN2 reçoit le signal SPNj. Les drains des transistors TP1, TP2, TN1, TN2 sont connectés à un noeud de sortie du pilote de ligne de mot, qui fournit la tension Vi,j à la ligne de mot correspondante WLi,j.

Les pilotes de ligne de mot Di,j sont ainsi de faible encombrement et sont adaptés à la réduction du pas technologique dans les mémoires en circuit intégré. La fourniture des tensions négatives ou positives est assurée par les décodeurs de groupe GPGEN et de sous-groupe DECGEN, SPGEN. De ce fait, la partie du décodeur selon l'invention assurant le postdécodage des signaux de prédécodage, comprenant ici les décodeurs GPGEN, DECGEN et SPGEN, est d'une structure plus complexe que celle d'un postdécodeur à tension positive, comme cela apparaîtra plus loin. Toutefois, la surface de silicium disponible pour réaliser les décodeurs de groupe et de sous-groupe est nettement plus étendue que celle qui est imposée par le pas technologique entre les lignes de mot, puisque chaque groupe ou sous-groupe couvre un ensemble de lignes de mot. La présente invention repose ainsi sur une complexification de la partie amont du décodeur, au profit d'une simplification de sa partie aval, qui est formée par les pilotes de ligne de mot.

Afin de fournir des signaux de polarité variable, les décodeurs GPGEN, SPGEN, DECGEN reçoivent des tensions VPOS et VNEG fournies par un générateur de tension PWGEN contrôlé par un séquenceur SEQ.

### Générateur de tension PWGEN et séquenceur SEQ

Le générateur PWGEN et le séquenceur SEQ sont représentés plus en détail sur la figure 3B, qui complète la figure 3A. Le générateur PWGEN comprend une pompe de charges PMP1 délivrant la tension VNEG, une pompe de charges délivrant la tension VPOS, un régulateur REG1 pour contrôler la tension VNEG et un régulateur REG2 pour contrôler la tension VPOS. Ces divers éléments du générateur PWGEN sont commandés par un circuit de contrôle CONTCT. Les tensions VPOS, VNEG sont appliquées aux décodeurs GPGEN, SPGEN, DECGEN.

Le circuit de contrôle CONTCT est piloté par un signal de mode MDS qui est fourni par le séquenceur SEQ en réponse à une commande CMD de lecture ou d'écriture du plan mémoire appliquée au séquenceur. Le séquenceur SEQ, à logique câblée ou à microprocesseur, fournit également des signaux SES ("Sector Erase Signal") et INVSEL ("Inverse Selection "). Les signaux MDS, SES sont appliqués au prédécodeur PREDEC1. Le signal INVSEL est appliqué au décodeur de groupe GPGEN.

### Fonctionnement du décodeur WLDEC2

Le fonctionnement du décodeur WLDEC2 est décrit par le tableau 2 ci-après. On distingue dans ce tableau les colonnes suivantes :

### Colonne "Modes"

Cette colonne décrit les modes de fonctionnement de la mémoire. On distingue un mode READ correspondant à la lecture de cellules mémoire, un mode PROG correspondant à la programmation de cellules mémoire, un mode PERASE ("Page Erase") correspondant à l'effacement d'une page (ligne de mot) du plan mémoire, et un mode SERASE ("Sector Erase") correspondant à l'effacement de tout un secteur. Ce dernier mode d'effacement est celui des mémoires Flash classiques n'ayant pas de décodeur à tension négative sélective.

### Colonne "SES"

Cette colonne décrit la valeur du signal SES ("Sector Erase Signal"). Ce signal détermine si une opération d'effacement doit être appliquée à tout un secteur (mode SERASE) ou seulement à une page du plan mémoire (mode PERASE). Le signal SES est mis à 1 en réponse à une commande d'effacement par secteur (mode SERASE) et à 0 en réponse à une commande d'effacement par page (mode PERASE). Sa valeur par défaut est 0 dans les modes PROG et READ.

### Colonne "MDS"

Cette colonne décrit la valeur du signal de mode MDS, qui comprend ici deux bits B1, B2. Le bit B1 est mis à 1 quand la tension VNEG doit être portée à une valeur négative et est mis à 0 quand la tension VNEG doit être mise à 0 (masse). Le bit B2 est mis à 0 quand la tension VPOS doit être portée à une valeur positive et est mis à 1 quand la tension VPOS doit être mise à 0 (masse).

### Colonne "INVSEL"

Cette colonne décrit la valeur du signal INVSEL ("Inverse Selection"), qui est à 0 dans les modes READ et PROG et à 1 dans les modes PERASE et SERASE. Le signal INVSEL permet d'inhiber les signaux PDj dans les modes READ et PROG et d'inhiber les signaux PSj dans les modes PERASE et SERASE. Plus particulièrement, les signaux PDj sont forcés à 0 dans le mode READ et sont forcés à 1 dans le mode PROG, tandis que les signaux PSj sont forcés à 1 dans les modes PERASE et SERASE. Cela permet d'inhiber le décodeur de sous-groupe DECGEN dans les modes READ et PROG afin de porter les signaux DECj, DECNj à des valeurs fixes et prédéterminées décrites par le tableau 2. Cela permet également d'inhiber le décodeur de sous-groupe SPGEN dans les modes PERASE et SERASE afin de porter les signaux SPj, SPNj à des valeurs fixes et prédéterminées décrites par le tableau 2.

### Colonne "VNEG"

Cette colonne décrit la valeur de la tension VNEG dans les quatre modes de fonctionnement du décodeur. Dans le mode READ, la tension VNEG est égale à une tension de non-lecture VNREAD qui est ici égale à 0V. Dans le mode PROG, la tension VNEG est égale à une tension d'inhibition de programmation VPINHIB qui est ici égale à - 1,5V. Dans le mode PERASE et SERASE, la tension VNEG est égale à une tension d'effacement négative VER qui est ici égale à -9V.

### Colonne "VPOS"

Cette colonne décrit la valeur de la tension VPOS dans les quatre modes de fonctionnement du décodeur. Dans le mode READ, la tension VPOS est égale à une tension de lecture VREAD qui est ici égale à 4,5V. Dans le mode PROG, la tension VPOS est égale à une tension de programmation VPP qui est ici égale à 7,5V. Dans le mode PERASE et SERASE, la tension VPOS est égale à une tension d'inhibition d'effacement VEINHIB qui est ici égale à 0V.

### Colonne "état"

Cette colonne décrit l'état sélectionné (SEL) ou non sélectionné (UNS) d'une ligne de mot, en fonction des signaux de prédécodage Lx(a), Ly(b), PSj, PDj fournis par le prédécodeur.

### Colonnes "Lx (a)", "Ly (b)", "PSj", "PDj"

Ces colonnes décrivent, dans les quatre modes de fonctionnement du décodeur, des exemples de valeurs de signaux de prédécodage pour des lignes de mot sélectionnées ou non sélectionnées. Comme indiqué plus haut, le signal PDj est forcé à 0 dans le mode READ et est forcé à 1 dans le mode PROG, tandis que le signal PSj est forcé à 1 dans les modes PERASE et SERASE. Une ligne de mot WLi,j est dans l'état sélectionné lorsque les signaux de prédécodage correspondants Lx(a), Ly(b), PSj (modes READ, PROG) ou Lx(a), Ly(b), PDj (modes PERASE, SERASE) sont simultanément à 1. Le signal de sélection LBS n'est pas décrit dans un souci de simplicité, et l'on considère que le tableau 2 décrit les opérations intervenant dans un secteur sélectionné (LBS=1).

### Colonnes "GPi", "SPj", "SPNj", "DECj", "DECNj"

Ces colonnes décrivent, dans les quatre modes de fonctionnement du décodeur, les valeurs des signaux GPi, SPj, SPNj, DECj, DECNj correspondant aux valeurs des signaux de prédécodage Lx(a), Ly(b), PSj, PDj et aux valeurs des tensions VNEG et VPOS. Ces signaux sont exprimés en Volt et correspondent aux valeurs attribuées aux tensions VNEG et VPOS, soit VNREAD et VREAD dans le mode READ, VPINHIB et VPP dans le mode PROG, VER et VEINHIB dans les modes PERASE et SERASE, soit ici 0V et 4,5 V, -1,5V et 7,5V, -9V et 0V, respectivement. Les signaux DECj et DECNj sont forcés à 0V et 4,5V dans le mode READ car le signal de prédécodage PDj est forcé à 0, et sont forcés à -1,5V et 7,5V dans le mode PROG car le signal de prédécodage PDj est forcé à 1. De même les signaux SPj et SPNj sont forcés à 0 et -9V dans les modes PERASE et SERASE car le signal de prédécodage PSj est forcé à 1.

On notera que le signal DECNj est l'inverse du signal DECj et que le signal SPNj est l'inverse du signal SPj, dans un système de signaux logiques où les tensions VNEG et VPOS définissent respectivement le 0 et le 1 logique.

### Colonne "Vi,j"

Cette colonne décrit la valeur de la tension Vi,j appliquée à une ligne de mot sélectionnée ou non sélectionnée, dans chacun des modes de fonctionnement. Dans le mode READ, une ligne de mot sélectionnée reçoit la tension de lecture VREAD (ici 4,5V) tandis qu'une ligne non sélectionnée reçoit la tension de non-lecture VNREAD (ici 0V). Dans le mode PROG, une ligne de mot sélectionnée reçoit la tension de programmation ou rafraîchissement VPP (ici 7,5V) tandis qu'une ligne de mot non sélectionnée reçoit la tension d'inhibition de programmation VPINHIB (ici -1,5V) qui protège les cellules mémoire contre un stress de drain pouvant entraîner une programmation parasite. Dans le mode PERASE, une ligne de mot sectionnée (formant la page à effacer) reçoit la tension d'effacement négative VER (ici - 9V) tandis qu'une ligne de mot non sélectionnée reçoit la tension d'inhibition d'effacement VEINHIB (ici 0V). Cette tension protège les cellules mémoire contre un effacement parasite en faisant diminuer la différence de tension source-grille des transistors à grille flottante, car une tension positive est appliquée sur les sources des toutes les cellules mémoire du secteur, comme décrit dans la demande WO 02/41322. Dans le mode PERASE, toutes les lignes de mot du secteur sélectionné reçoivent la tension d'effacement négative VER tandis que les lignes de mot des autres secteurs reçoivent la tension d'inhibition d'effacement VEINHIB.

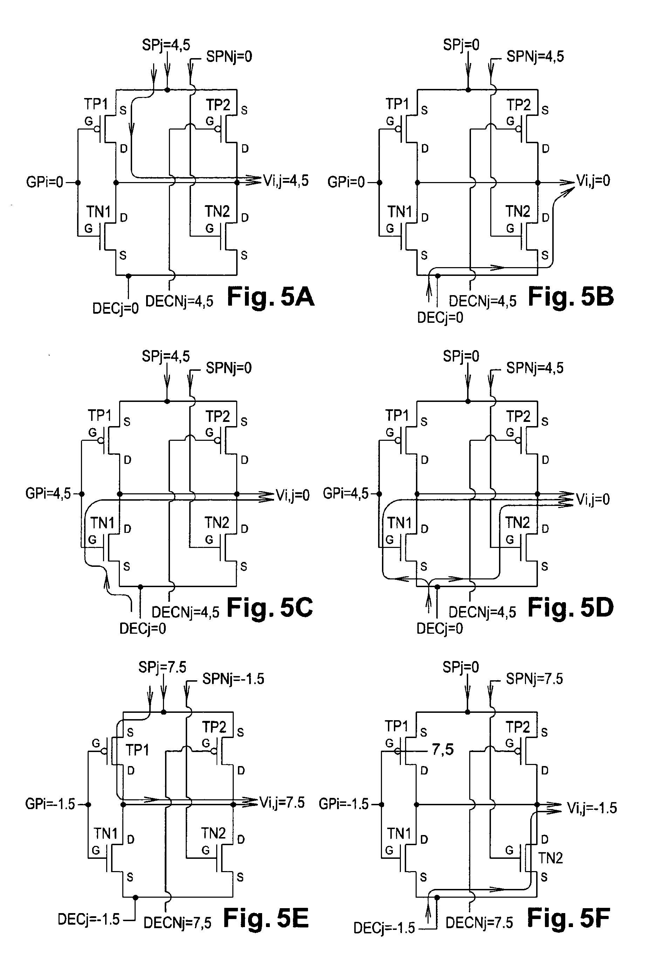

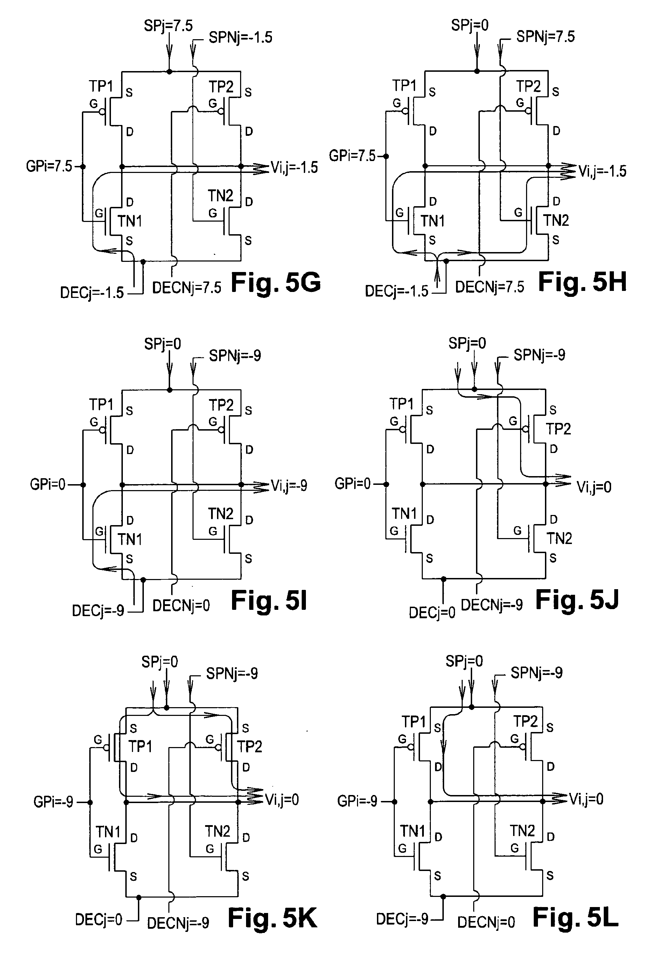

### Colonne "Figures 5A - 5L"

Les figures 5A à 5L illustrent le fonctionnement d'un pilote de ligne de mot Di,j dans chacune des configurations électriques décrites par le tableau 2, respectivement. On voit sur ces figures que la valeur du signal Vi,j fournit à la ligne de mot dépend de la combinaison des signaux GPi, SPj, SPNj, DECj, DECNj, un des transistors TP1, TP2 TN1, TN2, parfois deux, étant passant et les autres bloqués, le ou les transistors passants assurant le cheminement d'un des signaux SPj, DECj jusqu'au noeud de sortie (les signaux GPi, SPNj, DECNj étant utilisés ici comme signaux de commande de grille). Les tensions appliquées aux caissons P et N des transistors ne sont pas représentées dans un souci de simplicité, à l'exception de la configuration de la figure 5F où il doit être signalé qu'une tension de 7,5 V appliquée au caisson du transistor TP1 permet de maintenir ce transistor dans l'état bloqué.

En résumé, le décodeur selon l'invention permet de prévoir des pilotes de ligne de mot Di,j d'une structure simple et compatible avec les mémoires à haute densité de lignes de mot, pour appliquer des tensions négatives ou positives de façon sélective à ces lignes de mot.

On décrira maintenant des exemples de réalisation d'un élément de décodage de groupe GPGENi, d'un élément de décodage de sous-groupe SPGENj et d'un élément de décodage de sous-groupe DECGENj. Dans ce qui suit, les transistors de type NMOS sont désignés par des signes de référence commençant par "TN" et les transistors de type PMOS par des signes de référence commençant par "TP".

### Elément de décodage de groupe GPGENi

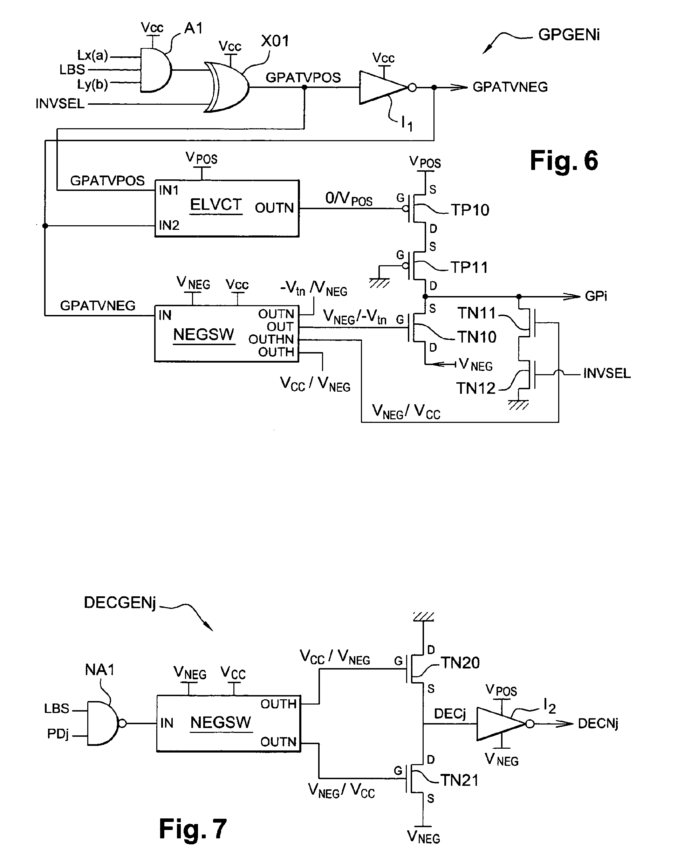

La figure 6 représente un élément GPGENi, fournissant un signal de sélection de groupe GPi. L'élément GPGENi comprend une porte A1 de type ET recevant en entrée les signaux Lx(a), Ly(b), LBS, dont la sortie est appliquée sur une entrée d'une porte XO1 de type OU Exclusif, qui reçoit sur son autre entrée le signal INVSEL. La sortie de la porte XO1 fournit un signal GPATVPOS ("GPi at VPOS") appliqué à une porte inverseuse I1 dont la sortie fournit un signal GPATVNEG ("GPi at VNEG"). Ces diverses portes logiques sont alimentées par la tension Vcc et les signaux logiques GPATVPOS, GPATVNEG sont du type 0/Vcc.

L'élément GPGEN comprend également une branche d'élévation de tension comprenant en série un transistor TP10, un transistor TP11, et un transistor TN10. La tension VPOS est appliquée à la source du transistor TP10 dont le drain est connecté à la source du transistor TP11. Le drain du transistor TP11 est connecté au drain du transistor TN10 dont la source reçoit la tension VNEG. Le transistor TP11 est un transistor cascode dont la grille est par exemple reliée à la masse.

Le signal GPi est fourni par le noeud de drain des transistors TP11 et TN10, formant la sortie de l'élément GPGENi. Ce noeud de drain est par ailleurs relié à la masse par deux transistors TN11, TN12 en série. La grille du transistor TN12 est pilotée par le signal INVSEL.

L'élément GPGENi comprend également un circuit élévateur de tension ELVCT alimenté par la tension VPOS. Le circuit ELVCT comporte une entrée IN1 recevant le signal GPATVPOS, une entrée IN2 recevant le signal GPATVNEG et une sortie OUTN qui pilote la grille du transistor TP10. La sortie OUTN, qui est une sortie inverseuse relativement à l'entrée IN1, délivre un signal égal à VPOS quand l'entrée IN1 est à 0, et un signal égal à 0 quand l'entrée IN1 est à 1 (Vcc) (Cf. tableau 7 décrit plus bas).

L'élément GPGENi comprend également un circuit commutateur de tension négative NEGSW alimenté par les tensions Vcc et VNEG. Le circuit NEGSW comporte une entrée IN sur laquelle le signal GPATVNEG est appliqué, une sortie non inverseuse OUT de bas niveau qui pilote la grille du transistor TN10, une sortie inverseuse OUTHN de haut niveau qui pilote la grille du transistor TN11. Le circuit NEGSW comporte également une sortie inverseuse OUTN de bas niveau et une sortie non inverseuse OUTH de haut niveau, non utilisées ici. Les tensions délivrées par ces diverses sorties en fonction du signal appliqué sur l'entrée IN sont décrites par le tableau 8 ci-après, certaines étant fonction du mode de fonctionnement de la mémoire.

La valeur du signal de sélection GPi, égale à VPOS, VNEG ou 0, est fonction des signaux Lx(a), Ly(b), LBS, INVSEL, comme décrit par le tableau 2 et les tableaux 3 et 4 ci-après, dans lesquels on considère que LBS=1. Dans le mode PERASE ou SERASE (VPOS=0), la mise à 0 du signal GPi est assuré par le transistor TN11 lorsque la sortie OUTHN du circuit NEGSW passe à Vcc, car le signal INVSEL est à 1 et lé transistor TN12 est passant (Cf. dernière ligne du tableau 4).

### Elément de décodage de sous-groupe DECGENj

La figure 7 représente un élément de décodage de sous-groupe DECGENj, fournissant un signal de sélection de sous-groupe DECj et son complément DECNj. L'élément DECGENj comprend une porte NA1 de type NON ET alimentée par la tension Vcc, recevant en entrée les signaux LBS et PDj. La sortie de la porte NA1 est appliquée sur l'entrée IN d'un circuit commutateur de tension négative NEGSW, conforme à celui décrit plus haut et alimenté par les tensions Vcc et VNEG. La sortie OUTH du circuit NEGSW est appliquée à la grille d'un transistor TN20 dont le drain est connecté à la masse. La sortie OUTN est appliquée à la grille d'un transistor TN21 dont la source reçoit la tension VNEG. Les transistors TN20, TN21 sont agencés en série et leur noeud de drain fournit le signal DECj. Le signal DECNj est fournit par une porte inverseuse I2 alimentée par les tensions VPOS et VNEG, dont l'entrée reçoit le signal DECj. Dans le mode PERASE, le signal DECj est ainsi égal à 0 ou à VNEG (-9V) et le signal DECNj égal à 0 (VPOS=0) ou à VNEG, selon la valeur du signal PDj, comme décrit par le tableau 2 et le tableau 5 ci-après, dans lesquels on suppose que LBS=1.

### Elément de décodage de sous-groupe SPGENj

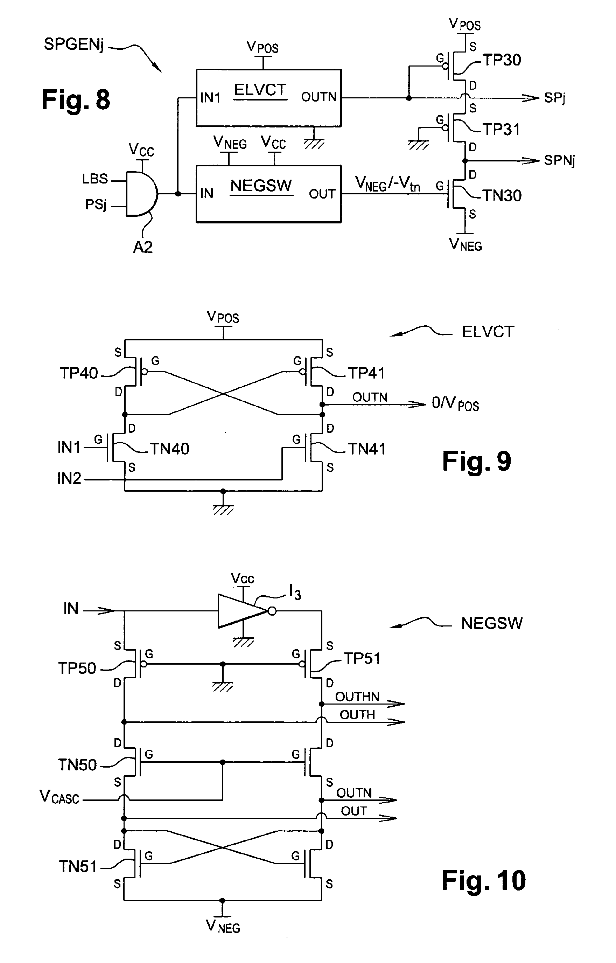

La figure 8 représente un élément de décodage de sous-groupe SPGENj, fournissant un signal de sélection de sous-groupe SPj et son complément SPNj. L'élément SPGENj comprend une porte A2 de type ET alimentée par la tension Vcc, recevant en entrée les signaux LBS et PSj. La sortie de la porte A2 est appliquée sur l'entrée IN d'un circuit commutateur de tension négative NEGSW du type déjà décrit, alimenté par les tensions VNEG et Vcc, dont la sortie OUT pilote la grille d'un transistor TN30 recevant la tension VNEG sur sa source. La sortie de la porte A2 est également appliquée sur l'entrée IN1 d'un circuit élévateur de tension ELVCT du type déjà décrit, alimenté par la tension VPOS, dont la sortie OUTN fournit le signal SPj. Le signal SPj est appliqué sur la grille d'un transistor TP3 dont la source reçoit la tension VPOS. Le drain du transistor TP30 est connecté à la source d'un transistor cascode TP31 dont la grille est reliée à la masse. Le drain du transistor TP31 est relié au drain du transistor TN30. Le signal SPNj est prélevé sur le noeud de drain des transistors TP31, TN30.

Dans le mode READ ou PROG, le signal SPj est ainsi égal à 0 ou à VPOS (avec VPOS = VREAD ou VPP) et le signal DECNj est égal à VPOS ou VNEG (avec VNEG = VNREAD ou VPINHIB), selon la valeur du signal PSj, comme décrit par le tableau 2 et le tableau 6 ci-après, dans lesquels on suppose que LBS=1.

### Circuit élévateur de tension ELVCT

La figure 9 représente un exemple de réalisation du circuit élévateur de tension ELVCT. Le circuit ELVCT comprend deux branches en parallèle comprenant chacune deux transistors en série, respectivement TP40, TN40 et TP41, TN41, les sources des transistors TP40, TP41 recevant la tension VPOS et les sources des transistors TN40, TN41 étant connectées à la masse. La grille du transistor TP40 est connectée au drain du transistor TP41 dont la grille est connectée au drain du transistor TP40. La grille du transistor TN41 forme l'entrée IN1 et la grille du transistor TN40 forme l'entrée IN2 du circuit ELVCT. Le noeud de drain des transistors TP41, TN41 forme la sortie OUTN du circuit ELVCT. La sortie OUTN fournit un signal égal à VPOS quand l'entrée IN1 reçoit un signal égal à 0V et l'entrée IN2 reçoit un signal égal à Vcc, et fournit un signal égal à 0V quand l'entrée IN1 reçoit un signal égal à Vcc et l'entrée IN2 reçoit un signal égal à 0V. Le circuit ELVCT forme une sorte de bascule flip-flop assurant le verrouillage de la sortie OUTN tout en assurant une élévation de tension du niveau logique 1, comme décrit par le tableau 7 ci-après.

### Commutateur de tension négative NEGSW

La figure 10 représente un exemple de réalisation du commutateur de tension négative NEGSW. Celui-ci comprend deux branches en parallèle comportant chacune trois transistors, respectivement TP50, TN50, TN51 et TP51, TN52, TN53. L'entrée IN du commutateur NEGSW est connectée à la source du transistor TP50 et est reliée à la source du transistor TP51 par l'intermédiaire d'une porte inverseuse I3 alimentée par la tension Vcc. Le drain du transistor TP50 est connecté au drain du transistor TN50. La source du transistor TN50 est reliée au drain du transistor TN51 dont la source reçoit la tension VNEG. Le drain du transistor TP51 est connecté au drain du transistor TN52. La source du transistor TN52 est reliée au drain du transistor TN53 dont la source reçoit la tension VNEG. Les transistors TP50, TP51 sont des transistors cascode et ont leurs grilles reliées à la masse. Les transistors TN50, TN52 sont également des transistors cascode et leurs grilles sont polarisées par une tension VCASC. La grille du transistor TN53 est connectée au drain du transistor TN51 et la grille du transistor TN51 est reliée au drain du transistor TN53.

La sortie de bas niveau OUT du commutateur de tension négative est connectée au drain du transistor TN51 et la sortie inverseuse de bas niveau OUTN est connectée au drain du transistor TN53. La sortie de haut niveau OUTH est connectée au drain du transistor TP51 et la sortie inverseuse de haut niveau OUTHN est connectée au drain du transistor TP51. Lorsque la tension Vcc est appliquée sur l'entrée IN le transistor TN51 est passant et le transistor TN53 est bloqué. Lorsque l'entrée IN est mise à 0 le transistor TN51 est bloqué, la sortie de la porte I3 fournit la tension Vcc et le transistor TN53 est passant. Le commutateur NEGSW fonctionne ainsi comme une sorte de bascule flip-flop qui bascule dans un sens quand l'entrée IN reçoit la tension Vcc, et dans l'autre sens quand l'entrée IN reçoit une tension nulle. Les tensions délivrées par les sorties OUT, OUTN, OUTH, OUTHN sont décrites par le tableau 8 ci-après. On notera que les tensions délivrées par les sorties de bas niveau OUT, OUTN dépendent de la valeur de la tension VCASC et que celle-ci présente des valeurs différentes selon le mode de fonctionnement de la mémoire. La tension VCASC est ainsi égale à VPOS dans les modes de fonctionnement READ et PROG (soit quand la tension VNEG est égale à 0 ou à - 1,5V) et est égale à 0 dans les modes de fonctionnement PERASE, SERASE (soit quand la tension VNEG est égale à VERASE).

Il apparaîtra clairement à l'homme de l'art que le décodeur de ligne de mot qui vient d'être décrit est susceptible de diverses variantes de réalisation, notamment en ce qui concerne la réalisation des pilotes de ligne de mot, des décodeurs de groupe et des décodeurs de sous-groupe, tout en restant dans le cadre de la présente invention.

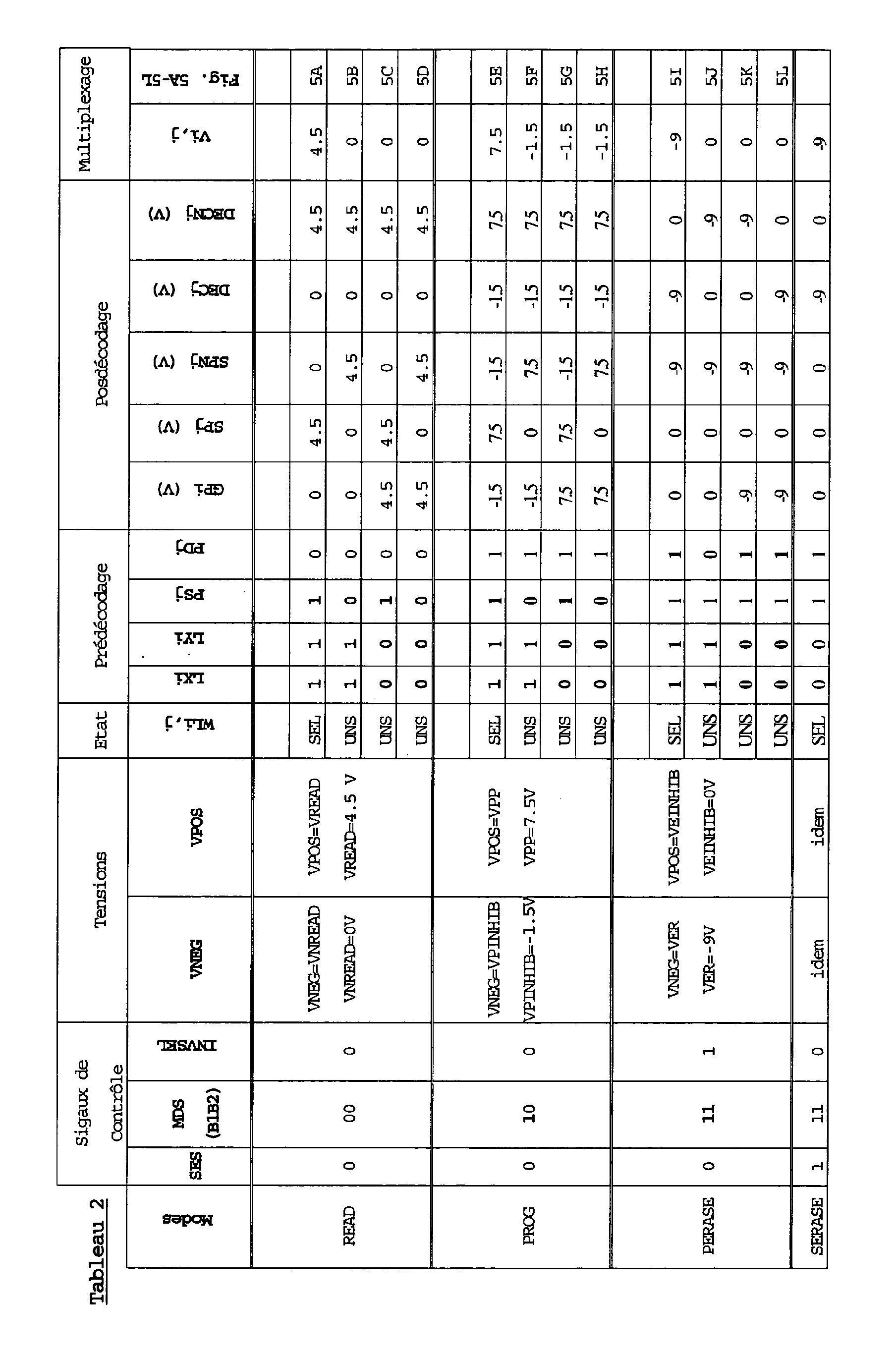

**Tableau 3**

| (élément de décodage de groupe GPGENi) | | | |
|---|---|---|---|
| **Lx (a) ET Ly (b)** | **INVSEL** | **GPATVPOS** | **GPATVNEG** |
| 0 | 0 | 0 | 1 |
| 0 | 1 | 1 | 0 |
| 1 | 0 | 1 | 0 |
| 1 | 1 | 0 | 1 |

**Tableau 4**

| (élément de décodage de groupe GPGENi) | | | | | | |
|---|---|---|---|---|---|---|
| **INVSEL** | **GPATVPOS IN1 (ELVCT)** | **GPATVNEG IN(NEGSW) IN2 (ELVCT)** | **OUTN(ELVCT**) | **OUT (NEGSW)** | **OUTHN (NEGSW)** | **GPi** |
| 0 | 0 | 1 | 1 (VPOS) | 1 (Vcc) | 0 (VNEG) | **VNEG** |
| 0 | 1 | 0 | 0 (0V) | 0 (VNEG) | 1 (Vcc) | **VPOS** |
| 1 | 0 | 1 | 1 (VPOS) | 1 (-Vtn) | 0 (VNEG) | **VNEG** |
| 1 (Vcc) | 1 | 0 | 0 (0V) | 0 (VNEG) | 1 (Vcc) | 0 |

**Tableau 5**

| (élément de décodage de sous-groupe DECGENj ) | | | | |
|---|---|---|---|---|
| **PDj IN(NEGSW)** | **OUTH(NEGSW)** | **OUTN(NEGSW)** | **DECj** | **DECNj** |
| 0 (0V) | 0 (VNEG) | 1 (-Vtn) | VNEG | VPOS |
| 1 (Vcc) | 1 (Vcc) | 0 (VNEG) | 0V | **X (*)** |

| | | | | |
|---|---|---|---|---|
| **(*) X=VPOS si VNEG=0 (mode READ) X=VNEG si VPOS=0 (mode PERASE) .** | | | | |

**Tableau 6**

| (élément de décodage de sous-groupe SPGENj) | | | | | |
|---|---|---|---|---|---|
| **VNEG** | **PSj** | **IN** **(NEGSW)** | **OUT** **(NEGSW)** | **SPj** | **SPNj** |
| VNREAD (0V) ou VPINHIB (-1,5V) | 0 (0V) | 0 (0V) | VNEG | 0 (0V) | 1 (VPOS) |
| VNREAD (0V) ou VPINHIB (-1,5V) | 1 (Vcc) | 1 (Vcc) | Vcc | 1 (VPOS) | 0 (VNEG) |
| VER (-9V) | 0 (0V) | 0 (0V) | VNEG | 0V | 0V |
| VER (-9V) | 1 (Vcc) | 1 (Vcc) | -Vtn | 0V | 0V |

**Tableau 7**

| (circuit élévateur de tension ELVCT) | | |
|---|---|---|
| **IN1 (ELVCT)** | **IN2 (ELVCT)** | **OUTN (ELVCT)** |
| 0 (0V) | 1 (Vcc) | 1 (VPOS) |
| 1 (Vcc) | 0 (0V) | 0 (0V) |

**Tableau 8**

| (commutateur de tension négative NEGSW) | | | | | |
|---|---|---|---|---|---|
| **Modes** | **IN (NEGSW)** | **OUT (NEGSW)** | **OUTN (NEGSW)** | **OUTH(NEGSW)** | **OUTHN(NEGSW)** |
| ERASE / SERASE(*) | 1 (Vcc) | 1 (-Vtn) | 0 (VNEG) | 1 (Vcc) | 0 (VNEG) |
| | 0 (0V) | 0 (VNEG) | 1 (-Vtn) | 0 (VNEG) | 1 (Vcc) |
| READ / PROG(**) | 1 (Vcc) | 1 (Vcc) | 0 (VNEG) | 1 (Vcc) | 0 (VNEG) |
| | 0 (0V) | 0 (VNEG) | 1 (Vcc) | 0 (VNEG) | 1 (Vcc) |

| | | | | | |
|---|---|---|---|---|---|
| (*) VCASC = 0 | | | | | |
| (**) VCASC = VPOS | | | | | |

## Revendications

1. Décodeur d'adresse (WLDEC2) pour appliquer sélectivement à des lignes de mot (WLi,j) d'un plan mémoire (MA) des signaux (Vi,j) de polarité variable, négative ou positive, dont la valeur est fonction d'une adresse (ADR) de ligne de mot appliquée au décodeur, **caractérisé en ce qu'**il comprend :
- un décodeur de groupe (GPGEN) délivrant des signaux (GPi) de sélection de groupe de lignes de mot qui sont de polarité variable (VPOS, VNEG),
- au moins un décodeur de sous-groupe (DECGEN, SPGEN) délivrant des signaux (SPj, SPNj, DECj, DECNj) de sélection de sous-groupe de lignes de mot qui sont également de polarité variable, un sous-groupe de lignes de mot comprenant un ensemble de lignes de mot appartenant à des groupes de lignes de mot différents, et
- des pilotes de ligne de mot (Di,j) à raison d'un pilote de ligne de mot (Di,j) par ligne de mot (WLi,j), comprenant chacun des moyens (TP1, TP2, TN1, TN2) de multiplexage des signaux de sélection de groupe et de sous-groupe, pour sélectionner et appliquer sélectivement un de ces signaux à une ligne de mot.

2. Décodeur selon la revendication 1, dans lequel :
- un groupe de lignes de mot (GRPi) comprend un ensemble de lignes de mot ayant des bits d'adresse (A3-A7) de poids déterminé identiques, et
- un sous-groupe de lignes de mot comprend un ensemble de lignes de mot ayant des bits d'adresse (A8-A10) de poids déterminé identiques, tout en appartenant à des groupes de lignes de mot différents.

3. Décodeur selon la revendication 2, dans lequel un groupe de lignes de mot comprend un ensemble de lignes de mot ayant des bits d'adresse de poids fort (A3-A7) identiques, et un sous-groupe de lignes de mot comprend un ensemble de lignes de mot ayant des bits d'adresse de poids faible (A8-A10) identiques.

4. Décodeur selon l'une des revendications 1 à 3, dans lequel un pilote de ligne de mot comprend des transistors interrupteurs de type MOS (TP1, TP2, TN1, TN2) qui sont à la fois pilotés sur leur grille et polarisés sur leur drain et leur source par les signaux de sélection de groupe et de sous-groupe (SPj, SPNj, DECj, DECNj), et sont agencés pour sélectionner un de ces signaux et l'appliquer à une ligne de mot.

5. Décodeur selon la revendication 4, dans lequel un pilote de ligne de mot comprend des transistors interrupteurs (TP1, TP2, TN1, TN2) ayant chacun :
- une borne reliée à une ligne de mot,
- une borne recevant un signal de sélection de groupe ou de sous-groupe (GPi, SPj, DECj), et
- une grille recevant un signal de sélection de groupe ou de sous-groupe (GPi, SPj, DECj).

6. Décodeur selon l'une des revendications 1 à 5, dans lequel le décodeur de sous-groupe comprend :
- un premier décodeur de sous-groupe (DECGEN), délivrant des premiers signaux (DECj, DECNj) de sélection de sous-groupe dont la valeur est fonction de l'adresse de ligne de mot appliquée au décodeur pendant des phases (PERASE, SERASE) d'effacement de cellules mémoire, et est indépendante de l'adresse appliquée au décodeur pendant des phases (READ, PROGVER) de lecture ou de programmation de cellules mémoire, et
- un second décodeur de sous-groupe (SPGEN) délivrant des seconds signaux (SPj, SPNj) de sélection de sous-groupe dont la valeur est fonction de l'adresse de ligne de mot appliquée au décodeur pendant les phases de lecture ou de programmation (READ, PROGVER), et est indépendante de l'adresse appliquée au décodeur pendant les phases d'effacement (PERASE, SERASE).

7. Décodeur selon la revendication 6, dans lequel chacun des décodeurs de sous-groupe reçoit une première (VNEG) et une seconde (VPOS) tension de référence et fournit, en sus d'un signal de sélection de sous-groupe (DECj, SPj), un signal complémentaire de sélection de sous-groupe (DECNj, SPNj) égal à la seconde tension de référence (VPOS) quand le signal de sélection de sous-groupe est égal à la première tension de référence (VNEG) et égal à la première tension de référence (VNEG) quand le signal de sélection de sous-groupe est égal à la seconde tension de référence (VPOS).

8. Décodeur selon la revendication 7, dans lequel un pilote de ligne de mot comprend :
- des transistors MOS (TP2, TN2) dont les grilles sont pilotées par l'un des signaux complémentaires (DECNj, SPNj), et
- des transistors MOS (TP1, TN1) dont les grilles sont pilotées par des signaux (GPi) de sélection de groupe.

9. Décodeur selon l'une des revendications 7 et 8, dans lequel un pilote de ligne de mot comprend :
- un premier transistor MOS (TP1) ayant une borne de drain ou de source reliée à une ligne de mot (WLi, j), recevant sur sa grille un signal de sélection de groupe (GPi) et recevant sur une borne de source ou de drain un premier signal de sélection de sous-groupe (SPj),
- un deuxième transistor MOS (TN1) ayant une borne de drain ou de source reliée à la ligne de mot, recevant sur sa grille le signal de sélection de groupe (GPi) et recevant sur une borne de source ou de drain un second signal de sélection de sous-groupe (DECj),
- un troisième transistor MOS (TP2) ayant une borne de drain ou de source reliée à la ligne de mot, recevant sur sa grille un premier signal complémentaire de sélection de sous-groupe (DECNj) et recevant sur une borne de source ou de drain un second signal de sélection de sous-groupe (SPj), et
- un quatrième transistor MOS (TN2) ayant une borne de drain ou de source reliée à la ligne de mot, recevant sur sa grille un second signal complémentaire de sélection de sous-groupe (SPNj) et recevant sur une borne de source ou de drain un premier signal de sélection de sous-groupe (DECj).

10. Décodeur selon l'une des revendications 1 à 9, dans lequel les décodeurs de groupe et de sous-groupe reçoivent deux tensions de référence (VNEG, VPOS) qui sont respectivement égales à une tension de non-lecture (VNREAD) et à une tension de lecture (VREAD) pendant la lecture de cellules mémoire.

11. Décodeur selon l'une des revendications 1 à 10, dans lequel les décodeurs de groupe et de sous-groupe reçoivent deux tensions de référence (VNEG, VPOS) qui sont respectivement égales à une tension d'inhibition de programmation (VPINHIB) et à une tension de programmation (VPP) pendant la programmation de cellules mémoire.

12. Décodeur selon l'une des revendications 1 à 11, dans lequel les décodeurs de groupe et de sous-groupe reçoivent deux tensions de référence (VNEG, VPOS) qui sont respectivement égales à une tension d'effacement (VER) et à une tension d'inhibition d'effacement (VEINHIB) pendant l'effacement de cellules mémoire.

13. Décodeur selon les revendications 10, 11 et 12, dans lequel la tension de programmation est positive, la tension d'inhibition de programmation et la tension d'effacement sont négatives, les tensions de non lecture et d'inhibition d'effacement sont nulles.

14. Décodeur selon l'une des revendications 1 à 13, comprenant un étage de prédécodage (PREDEC1) fournissant des signaux de prédécodage (Lx(a), Ly(b), LBS) aux décodeurs de groupe et de sous-groupe.

15. Décodeur selon l'une des revendications 1 à 14, dans lequel le décodeur de groupe et le décodeur de sous-groupe fournissent des signaux de sélection positifs, négatifs ou nuls.

16. Décodeur selon l'une des revendications 1 à 15, dans lequel le décodeur de groupe (GPGEN) comprend des circuits élévateurs de tension (ELVCT) pour transformer un signal logique égal à 1 ayant un niveau de tension positif déterminé (Vcc) en un signal logique ayant un niveau de tension positif de valeur supérieure, égal à une tension de référence (VNEG) fournie aux circuits élévateurs de tension.

17. Décodeur selon l'une des revendications 1 à 16, dans lequel les décodeurs de groupe et de sous-groupe comprennent des commutateurs de tension (NEGSW, OUT) pour transformer des signaux logiques à 0 et à 1 en des signaux ayant des niveaux de tension négatifs différents (VPOS, -Vt).

18. Décodeur selon l'une des revendications 1 à 17, dans lequel les décodeurs de groupe et de sous-groupe comprennent des commutateurs de tension (NEGSW, OUTH) agencés pour transformer un signal logique à 0 en un signal de tension négative (VNEG) et signal logique à 1 en un signal de tension positive (Vcc).
